# EUROPEAN PATENT SPECIFICATION

(11) **EP 3 640 973 B1**
(45) Date of publication and mention of the grant of the patent: **18.03.2026**
(21) Application number: 18900952.5
(22) Date of filing: 13.12.2018
(51) Int. Cl.: H01L 21/3065, H05H 1/46, H01J 37/32

(54) **WIDE-GAP SEMICONDUCTOR SUBSTRATE, APPARATUS FOR MANUFACTURING WIDE-GAP SEMICONDUCTOR SUBSTRATE, AND METHOD FOR MANUFACTURING WIDE-GAP SEMICONDUCTOR SUBSTRATE**
HALBLEITERSUBSTRAT MIT BREITER SPALTE, VORRICHTUNG ZUR HERSTELLUNG EINES HALBLEITERSUBSTRATS MIT BREITER SPALTE UND VERFAHREN ZUR HERSTELLUNG EINES HALBLEITERSUBSTRATS MIT BREITER SPALTE
SUBSTRAT SEMI-CONDUCTEUR À LARGE BANDE INTERDITE, APPAREIL DE FABRICATION DE SUBSTRAT SEMI-CONDUCTEUR À LARGE BANDE INTERDITE, ET PROCÉDÉ DE FABRICATION DE SUBSTRAT SEMI-CONDUCTEUR À LARGE BANDE INTERDITE

(30) Priority: 17.01.2018 JP 2018005923
(43) Date of publication of application: 22.04.2020
(73) Proprietor: SPP Technologies Co., Ltd., Tokyo (JP)
(72) Inventor: YAMAMOTO, Takashi, Amagasaki-shi, Hyogo 660-0891 (JP)
(74) Representative: Isarpatent
(86) International application number: PCT/JP2018/045825
(87) International publication number: WO 2019/142556

(56) References cited:
- EP-A1- 0 553 691
- EP-A1- 2 048 703
- EP-B1- 2 048 703
- JP-A- 2005 123 425
- JP-A- 2005 123 425
- JP-A- 2007 035 756
- JP-A- 2007 073 844
- JP-A- 2007 150 036
- JP-A- 2009 277 720
- JP-A- 2015 076 460
- JP-A- 2015 202 990
- JP-A- 2015 202 990
- US-A1- 2008 076 334
- US-A1- 2009 186 483
- US-A1- 2014 017 900
- US-B2- 9 589 880

## Description

### Technical Field

0001 The present invention relates to a wide-gap semiconductor substrate for forming a device on a surface thereof, an apparatus for manufacturing a wide-gap semiconductor substrate, and a method for manufacturing a wide-gap semiconductor substrate.

### Background Art

0002 In recent years, electronic devices have been reduced in size, thickness, and weight, reduced in power loss (enhanced in efficiency), and enhanced in functionality (performance). Accordingly, a thin semiconductor device has been developed which is manufactured with a thinned silicon substrate. Particularly, a vertical power device has lower power loss when a silicon substrate (wafer) is thinner; therefore, it is preferred that such a device is manufactured with a silicon substrate having a minimum thickness with necessary voltage withstanding property. To this end, in manufacturing a thin power device, a silicon substrate is thinned to a desired thickness by grinding a back surface, i.e., a surface opposite to a surface on which functional layers are formed, of the silicon substrate. However, there are problems that the silicon substrate is cracked or chipped due to warpage occurring in thinning the silicon substrate and that the thinned silicon substrate is cracked when being conveyed. To solve these problems, for example, a technology is disclosed in Japanese Patent No. 6004100 in which a back surface of a silicon substrate is thinned by grinding only an inner area of the back surface of the silicon substrate with a peripheral area thereof left ungrinded. This technology enables reduction of cracking and warpage of the silicon substrate.

0003 Simultaneously, power devices are further required to have low on-state resistance and high withstand voltage. To meet these requirements, manufacture using a silicon carbide substrate instead of using a conventionally used silicon substrate has attracted attention. Silicon carbide has smaller crystal lattice constant (stronger interatomic bonding) than silicon, and has a band gap (2.2 eV or more, hereinafter referred to as "wide gap") greater than a band gap of silicon (1.12 eV). Further, a silicon carbide substrate has dielectric breakdown field strength (unit: V/cm) approximately 10 times as high as that of a silicon substrate. That is to say, in the case of using a silicon carbide substrate instead of a silicon substrate to manufacture an equivalent voltage withstanding product (device), a silicon carbide substrate having a thickness equal to only one tenth of that of the silicon substrate is used. For example, provided that a silicon carbide substrate has a withstand voltage of 100 V/µm, a silicon carbide substrate having a thickness of 15 µm can be used for a device having a withstanding voltage of 1200 V that is lower than 1500 V. On the other hand, in the case of using a silicon substrate to obtain an equivalent withstand voltage, the silicon substrate has to have a thickness of about 150 µm. Therefore, in the case where a silicon carbide substrate is used to manufacture a device having a required withstand voltage, it is preferred that the silicon carbide substrate has a thickness equal to one tenth of a thickness a silicon substrate is required to have to manufacture the device. Such a device is manufactured as follows: functional layers are formed on a surface of a silicon carbide substrate and then areas marked off by predetermined division lines are formed on the functional layers; subsequently, the silicon carbide substrate is thinned to a predetermined thickness by grinding a back surface of the silicon carbide substrate with a grinding device; and thereafter the silicon carbide substrate is divided into device chips by cutting the silicon substrate along the predetermined division lines with a cutting device, a laser processing device, or the like. The divided devices chips are each used for a power device.

0004 JP 2007073844 A discloses a wafer cutting method including an adhesive film sticking process for sticking a DAF to the back of a wafer; a cut groove formation process for forming a shallow cut groove without reaching the DAF on the street of the wafer; and a division process for cutting a region corresponding to a street from the side of the DAF, forming an opposing cut groove with a depth reaching the cut groove formed by the cut groove formation process, and dividing the wafer into each device.

0005 JP 2015202990 A discloses a manufacturing method of a compound semiconductor substrate capable of largely reducing warps and fractures of a substrate in a manufacturing process. Similarly, JP 2005123425 A discloses a semiconductor substrate manufacturing method having high processing accuracy and suited to mass production.

0006 JP 2007150036 A discloses a tool for plasma etching capable of preventing excessive etching at the outer-periphery of a wafer.

0007 US 2014/0017900 A1 discloses a plasma etching apparatus which performs plasma etching on a substrate having a resist pattern formed thereon and an outer edge portion where the substrate surface is exposed.

0008 US 2009/0186483 A1 discloses an etching amount calculating method that can stably and accurately calculate the amount of etching even if a disturbance is added.

0009 EP 0 553 691 A1 discloses an apparatus for CVD processing, wherein a wafer mounted on a vertically movable workpiece support means beneath a gas outlet or showerhead is raised into contact with a shield ring which normally rests on a ring support in a chamber of the apparatus.

0010 EP 2 048 703 A1 discloses a plasma etching method in which a special area for detecting an end point needs not to be set and an equipment therefor.

0011 Finally, US 9 589 880 B2 discloses a semiconductor substrate having a first substrate region as an inner region having a first thickness and a second substrate region surrounding an outer periphery of the first substrate region (70a') and having a second thickness greater than the first thickness, wherein the semiconductor substrate is a wide-gap semiconductor substrate having no device formed on the first substrate region. The first thickness of the first substrate region is not less than 10 µm and not more than 50 µm and the second substrate region is formed to have the second thickness of 100 µm to 350 µm and set to have a radial width of 1 mm to 10 mm.

### Summary of Invention

### Technical Problem

0012 For example, Japanese Patent No. 6004100 discloses a wafer thinning technology in which a wafer reinforced by a support substrate that is affixed to the wafer is entirely thinned with a grinding device. However, as described in Japanese Patent No. 6004100, using a grinding device has a problem that, if the wafer is to be thinned to an extremely small thickness (for example, 50 µm or less, which depends on the material of the wafer), the wafer is cracked or warped. Further, in the case where the wafer is a wide-gap semiconductor substrate made of silicon carbide or the like, the wafer has much higher hardness than a silicon substrate. Therefore, there is a problem that, when the back surface of the wafer is grinded with a grinding wheel including abrasives, the abrasives are worn out 4 to 5 times as much as the amount of grinding, which is very uneconomical. For example, abrasives are worn out by 0.1 µm when grinding a silicon substrate by 100 µm. On the other hand, abrasives are worn out by 400 to 500 µm when grinding a silicon carbide substrate by 100 µm; thus, abrasives are worn out 4000 to 5000 times as much as in the case of grinding a silicon substrate.

0013 Further, Japanese Patent No. 6004100 proposes that, in the case of thinning a wafer made of silicon carbide (SiC), the wafer is thinned by CMP because a SiC wafer cannot be melted. However, polishing a SiC wafer by CMP is impractical because of its low polishing rate. Further, both grinding and CMP have difficulty in thinning a recess having a small rectangular area and difficulty in discharging shavings from a recess, and have a problem it is necessary to remove distortion.

0014 Further, power devices are required to have lower on-state resistance and higher withstand voltage; therefore a wafer for such a power device is required to be further thinned.

0015 The present invention has been achieved in view of the above-described circumstances, and an object thereof is to provide a wide-gap semiconductor substrate which enables formation of a device having low power loss while maintaining high mechanical strength, a method for manufacturing such a wide-gap semiconductor substrate, and an apparatus for manufacturing such a wide-gap semiconductor substrate.

### Solution to Problem

0016 The present invention, for achieving the above-described objects, relates to a wide-gap semiconductor substrate (hereinafter in this section, simply referred to as "semiconductor substrate") with the features of claim 1, a wide-gap semiconductor substrate manufacturing apparatus with the features of claim 3, and a wide-gap semiconductor substrate manufacturing method with the features of claim 8.

0017 Because of having the first substrate region (thin-plate part), which has a thickness not less than 10 µm and not more than 50 µm, formed as an inner region thereof and having the second substrate region (thick-plate part), which has a thickness of 100 µm to 350 µm, formed along the outer periphery of the first substrate region, this semiconductor substrate is effectively prevented from being cracked or warped. Further, this semiconductor substrate enables a device formed on the thin-plate part thereof to have low on-state resistance.

0018 Therefore, it is possible to form a device having low power loss with mechanical strength of the semiconductor substrate maintained at high level.

0019 Further, in the semiconductor substrate described above, it is preferred that the semiconductor substrate is made of silicon carbide (4H-SiC, 6H-SiC, or 3C-SiC), gallium nitride (GaN), gallium oxide (GaO), or diamond (C).

0020 Such a semiconductor substrate has a band gap (2.2 eV or more) greater than a band gap of silicon (1.12 eV). Therefore, this semiconductor substrate enables a device formed on the thin-plate part thereof to have lower on-state resistance, so that the device has lower power loss.

0021 The manufacturing apparatus includes the outer-periphery covering mechanism that covers only a peripheral edge portion of a semiconductor substrate placed on the platen with the cover member during etching of the semiconductor substrate so that only the peripheral edge portion of the semiconductor substrate is not etched. Therefore, the cover member functions as a mask, so that only the peripheral edge portion of the semiconductor substrate is not etched and only the device formation region of the semiconductor substrate is etched. Thus, with this manufacturing apparatus, it is easy to thin only an inner region, where a device is formed, of a semiconductor substrate. Further, thinning only the inner region enables the semiconductor substrate to be effectively prevented from being cracked or warped. Furthermore, the thus-manufactured semiconductor substrate enables a device formed on the thin-plate part thereof to have low on-state resistance.

Further, in the manufacturing apparatus described above, it is preferred that the outer-periphery covering mechanism further includes a support member provided in the processing chamber to support the cover member and the outer-periphery covering mechanism is configured such that the cover member is brought into contact with and raised by the peripheral edge portion of the semiconductor substrate when the semiconductor substrate is lifted by the platen, thereby covering only the peripheral edge portion of the semiconductor substrate placed on the platen so that only the peripheral edge portion is not etched.

Further, in the manufacturing apparatus described above, it is preferred that the manufacturing apparatus further includes a depth monitor detecting a depth of etching of the semiconductor substrate and the depth monitor includes a depth sensor including a light source radiating a light toward an etched surface of the semiconductor substrate and the cover member, and a processing unit calculating the depth of etching based on reflected lights reflected by the etched surface and the cover member.

0022 With such a manufacturing apparatus, it is possible to start etching without carrying out previous steps such as measuring in advance an etching amount and calculating an etching rate (i.e., setting conditions) so as to recognize an etching end point based on the etching rate and an etching time. Therefore, with this manufacturing apparatus, the time for manufacturing the semiconductor substrate is greatly reduced.

0023 Further, in the manufacturing apparatus described above, it is preferred that the semiconductor substrate is made of silicon carbide (4H-SiC, 6H-SiC, or 3C-SiC), gallium nitride (GaN), gallium oxide (GaO), or diamond (C).

0024 Such a semiconductor substrate has a band gap (2.2 eV or more) greater than a band gap of silicon (1.12 eV). Therefore, this semiconductor substrate enables a device formed on the thin-plate part thereof to have lower on-state resistance, so that the device has lower power loss.

0026 In the manufacturing method, only a peripheral edge portion of a semiconductor substrate placed on a platen is covered with a cover member during etching of the semiconductor substrate so that only the peripheral edge portion is not etched; therefore, only the peripheral edge portion of the semiconductor substrate is not etched. Thus, with this manufacturing method, a semiconductor substrate is manufactured which has a thin-plate part formed at an inner region thereof and has a thick-plate part formed along an outer periphery of the thin-plate part. Such a semiconductor substrate is effectively prevented from being cracked or warped. Further, a device manufactured by forming it on the thin-plate part of such a semiconductor substrate has low on-state resistance.

0027 Note that, in this manufacturing method, it is preferred that a gap is formed between the semiconductor substrate and the cover member. In the case where the cover member is in contact with the semiconductor substrate when the semiconductor substrate is etched in a state where a bias potential is applied to the platen, depending on the material of the cover member, a bias potential is generated in the cover member. This causes a problem that the cover member is sputtered by ions in the plasma and the product of the sputtering adheres to the surface of the inner region, i.e., the surface of the thin-plat part, of the semiconductor substrate, which deteriorates surface accuracy of the surface of the thin-plat part. Forming a gap between the semiconductor substrate and the cover member enables prevention of generation of a bias potential in the cover member, which prevents the surface accuracy of the surface of the thin-plate part from being deteriorated due to the cover member being sputtered.

0028 It is preferred that the gap between the semiconductor substrate and the cover member is not less than 0.5 mm and not more than 3 mm. In the case where the gap is smaller than 0.5 mm, generation of a bias potential in the cover member is not effectively prevented. In the case where the gap is equal to or greater than 3 mm, an etching species enters between the semiconductor substrate and the cover member and etches the region covered by the cover member (the second substrate region) of the semiconductor substrate, which results in deterioration of the shape of the semiconductor substrate obtained, such as an inner peripheral edge (inner shoulder) of the second substrate region (the thick-plate part) being etched.

0029 Further, it is preferred that the cover member is made of quartz, aluminum oxide, or yttria or made of a material made by coating quartz, aluminum oxide, or yttria with a metal coating. Using aluminum oxide is disadvantageous in that sputtering as described above is likely to occur and such sputtering leads to deterioration of the surface accuracy of the surface of the thin-plate part, while it is advantageous in that the cover member is inexpensive to manufacture. Using yttria is disadvantageous in that the cover member is expensive to manufacture, while it is advantageous in that, even when sputtering as described above occurs, the product of the sputtering is likely to disappear and therefore the surface accuracy of the surface of the thin-plate part is less deteriorated. Further, using quartz is advantageous in that the cover member is less expensive to manufacture than in the case of using yttria and in that, even when sputtering as described above occurs, the product of the sputtering disappears and therefore the surface accuracy of the surface of the thin-plate part is hardly deteriorated. In the case of using quartz, although the cover member is etched by an etching species, loading is alleviated by the etching of the cover member, so that the thin-plate part is etched to have a uniform thickness.

0030 In this manufacturing method, it is preferred that the semiconductor substrate is etched to have a thickness of 50 µm or less.

0031 In such a manufacturing method, the device formation region of the semiconductor substrate is etched to have a thickness of 50 µm or less. Therefore, this manufacturing method enables a device formed in the thinned region to have lower on-state resistance, so that the device has lower power loss.

0032 In this manufacturing method, it is preferred that the etching gas includes a fluorine-containing gas.

0033 In this manufacturing method, it is preferred that the bias potential is applied to the platen by supplying an RF power of 500 W or more to the platen and a pressure inside the processing chamber is 30 Pa or less.

0034 Because of the bias potential being applied to the platen by supplying an RF power of 500 W or more to the platen, such a manufacturing method etches even a semiconductor substrate with strong interatomic bonding rapidly. Further, because the pressure inside the processing chamber is 30 Pa or less, the plasma is stabilized and in-plane uniformity of the amount of etching is thereby enhanced.

0035 In this manufacturing method, it is preferred that the semiconductor substrate is made of silicon carbide (4H-SiC, 6H-SiC, or 3C-SiC), gallium nitride (GaN), gallium oxide (GaO), or diamond (C).

0036 In such a manufacturing method, the semiconductor substrate has a band gap (2.2 eV or more) greater than a band gap of silicon (1.12 eV). Therefore, a device formed on the thin-plate part of the semiconductor substrate has lower on-state resistance, so that the device has lower power loss.

### Advantageous Effects of Invention

0037 As described above, the wide-gap semiconductor substrate according to the present invention has a thin-plate part formed at an inner region thereof where a device is formed, and has a thick-plate part formed along an outer periphery of the thin-plate part. With this semiconductor substrate, it is possible to form a device having low power loss with mechanical strength of the semiconductor substrate maintained at high level.

0038 Further, the wide-gap semiconductor substrate manufacturing apparatus according to the present invention is configured such that only a peripheral edge portion of a wide-gap semiconductor substrate is covered so that only the peripheral edge portion is not etched; therefore, only the peripheral edge portion of the wide-gap semiconductor substrate is not etched. With this manufacturing apparatus, it is easy to thin only an inner region, where a device is formed, of a wide-gap semiconductor substrate.

0039 Furthermore, the wide-gap semiconductor substrate manufacturing method according to the present invention is configured such that only a peripheral edge portion of a wide-gap semiconductor substrate is covered during etching of the wide-gap semiconductor substrate so that only the peripheral edge portion is not etched. With this manufacturing method, it is easy to thin only an inner region, where a device is formed, of a wide-gap semiconductor substrate.

### Brief Description of Drawings

0040
Fig. 1 shows (a) a vertical sectional view of a semiconductor substrate not comprised by the present invention, and (b) a plan view of the semiconductor substrate;
Fig. 2 is a sectional view of a schematic configuration of an etching apparatus (manufacturing apparatus) used for manufacturing the semiconductor substrate illustrated in Fig. 1;
Fig. 3 shows vertical sectional views showing steps of a method of manufacturing the semiconductor substrate illustrated in Fig. 1;
Fig. 4 shows vertical sectional views showing steps of the method of manufacturing the semiconductor substrate illustrated in Fig. 1;
Fig. 5 is a vertical sectional view of a schematic configuration of an etching apparatus (manufacturing apparatus) according to a second embodiment of the present invention;
Fig. 6 is a diagram illustrative of a manufacturing method and a manufacturing apparatus according to another embodiment of the present invention;
Fig. 7 is a plan view of a wide-gap semiconductor substrate according to an embodiment of the present invention; and
Fig. 8 is a plan view of a cover member used for manufacturing the wide-gap semiconductor substrate illustrated in Fig. 7.

### Description of Embodiments

0041 Hereinafter, embodiments of the present invention will be described with reference to the drawings.

0042

### [First Embodiment]

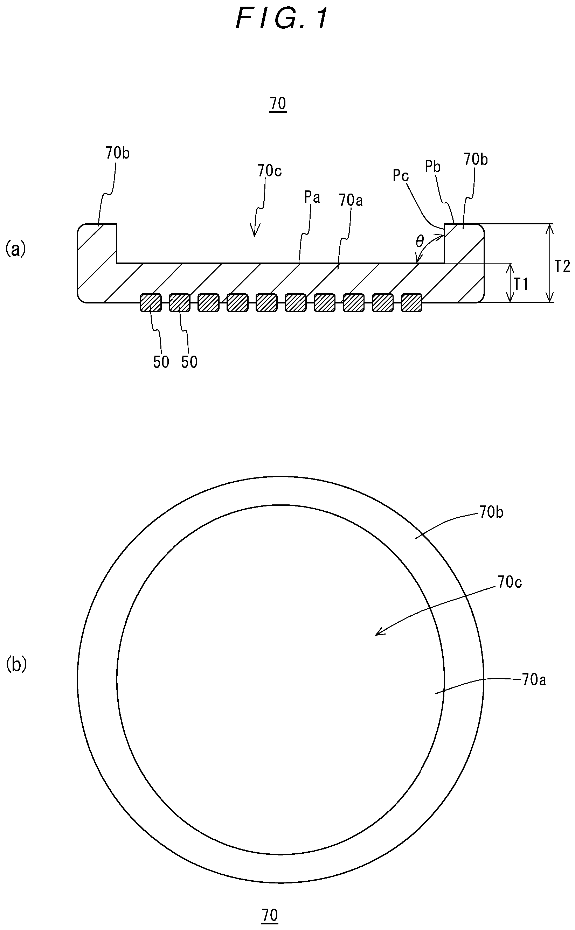

Fig. 1(a) is a vertical sectional view of a semiconductor substrate 70 not comprised by the present invention. Fig. 1(b) is a plan view of the semiconductor substrate 70. The semiconductor substrate 70 is a wide-gap semiconductor substrate made of silicon carbide (4H-SiC) having high voltage withstanding properties. An electronic device manufactured with this semiconductor substrate 70 has low power loss, which is used as a high-performance and power-saving inverter, power module for household electrical appliance, or power semiconductor device for electric vehicle.

0043 Further, silicon carbide has a higher Young's modulus than silicon and has the property of having high yield temperature even in a high-temperature environment. Therefore, silicon carbide is used as an MEMS (Micro-Electro Mechanical Systems) device having both electric circuit elements and fine mechanical elements, which is currently used in an acceleration sensor, a printer head, a pressure sensor, a DMD (Digital Micromirror Device), etc. and the market scale of which is increasingly expanded.

0044 As shown in Figs. 1(a) and 1(b), the semiconductor substrate 70 according to this embodiment consists of a thin-plate part (first substrate region) 70a as an inner region having a circular shape in plan view and having a thickness T1 (not less than 10 µm and not more than 50 µm), and a thick-plate part (second substrate region) 70b as an outer annular region formed along the outer periphery of the thin-plate part 70a and having a thickness T2 (>T1). That is to say, the semiconductor substrate 70 has a recess 70c having a circular shape in plan view and formed at a region corresponding to the thin-plate part 70a as the inner region. The thick-plate part 70b is formed to be concentric with the thin-plate part 70a and surround the outer periphery of the thin-plate part 70a. Note that the recess 70c may have any area, which is determined in accordance with a mechanical strength the semiconductor substrate 70 is required to have.

0045 As shown in Fig. 1(a), an angle θ formed by a planar surface Pa of the thin-plate part 70a and a plane (an inner peripheral surface of the thick-plate part 70b) connecting the planar surface Pa to a planar surface Pb of the thick-plate part 70b is approximately a right angle.

0046 As shown in Fig. 1(a), devices 50 each having a size of several mm square are formed on a surface opposite to the surface Pa of the thin-plate part 70a (i.e., a back surface of the thin-plate part 70a that is illustrated as a lower surface in Fig. 1(a)). The devices 50 include vertical power devices (an insulated gate bipolar transistor (IGBT), an MOS field effect transistor (MOSFET), a diode, etc.).

0047 The thick-plate part 70b as the outer region serves to maintain mechanical strength of the semiconductor substrate 70 so as to prevent the semiconductor substrate 70 from being cracked or warped while it is conveyed or subjected to heat treatment. For example, the thickness T2 of the thick-plate part 70b is in a range of 100 µm to 350 µm. Setting the thickness T2 in this range enables the semiconductor substrate 70 to be effectively prevented from being cracked or warped. In contrast, the thin-plate part 70a has the thickness T1 not less than 10 µm and not more than 50 µm. Setting the thickness T1 in this range enables the devices 50 formed on the surface of the thin-plate part 70a to have low on-state resistance, while the mechanical strength of the semiconductor substrate 70 is maintained at high level. Therefore, it is possible to manufacture a device having lower power loss with the mechanical strength of the semiconductor substrate 70 maintained at high level.

0048 Note that the recess 70c in the example described here has a circular planer shape. For example, the planar shape of the recess 70c may be a rectangular shape, a rounded quadrangular shape (quadrangular shape with rounded corners), a polygonal shape, etc. The recess 70c may have any planar shape which is appropriate to the shapes of devices to be formed. Such a configuration also provides the same effects as the example described here. Further, the angle θ in this embodiment is approximately a right angle (90 degrees). The angle θ may be an acute angle or an obtuse angle. Such a configuration also provides the same effects as the example described here. Furthermore, this embodiment describes an example configuration in which one recess is formed; however, a configuration is possible in which two or more recesses are formed.

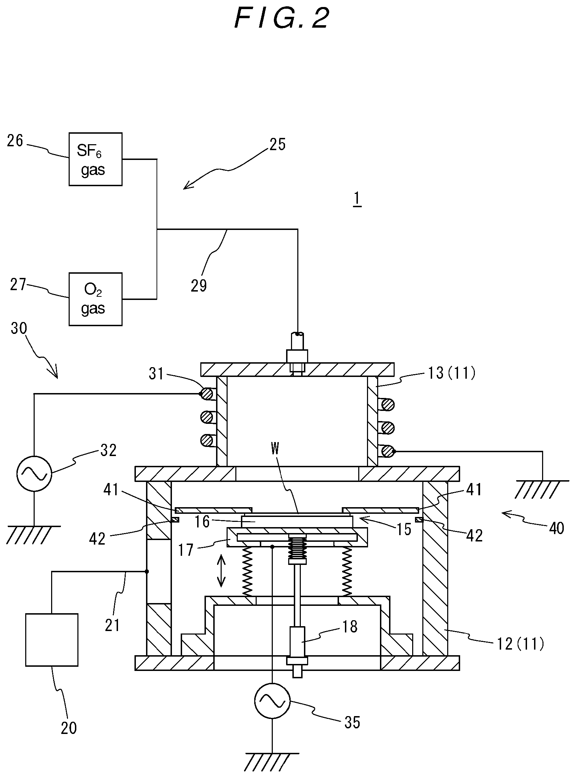

0049 Next, an etching apparatus 1, which is a manufacturing apparatus for manufacturing the semiconductor substrate 70 according to this embodiment, is described with reference to Fig. 2. Fig. 2 is a sectional view of a schematic configuration of the etching apparatus 1 used for manufacturing the semiconductor substrate 70 illustrated in Fig. 1.

0050 As shown in Fig. 2, the etching apparatus 1 includes a processing chamber 11 having a closed space, a platen 15 which is disposed in the processing chamber 11 in such a manner that it is able to be lifted and lowered and on which a wafer W to be etched is to be placed, a lifting cylinder (lifting device) 18 lifting and lowering the platen 15, an exhaust device 20 reducing the pressure inside the processing chamber 11, a gas supply device (processing gas supply unit) 25 supplying a processing gas into the processing chamber 11, a plasma generating device 30 generating plasma from the processing gas supplied into the processing chamber 11, an RF power supply (substrate power supply unit) 35 supplying RF power to the platen 15, and an outer-periphery covering mechanism 40 covering a peripheral edge portion (non-etched portion) of the wafer W. This etching apparatus 1 etches a wafer W placed on the platen 15 disposed in the processing chamber 11 by means of plasma generated from an etching gas so that only a device formation region of the wafer W, where a device is to be formed, is thinned. Note that the outer-periphery covering mechanism 40 functions to cover only the peripheral edge portion of the wafer W placed on the platen 15 during etching of the wafer W so that only the peripheral edge portion is not etched.

0051 The processing chamber 11 is composed of a lower chamber 12 and an upper chamber 13, interior spaces of which communicate with each other. The upper chamber 13 is formed to be smaller than the lower chamber 12. The platen 15 is composed of an upper member 16 on which a wafer W is to be formed, and a lower member 17 to which the lifting cylinder 18 is connected. The platen 15 is disposed in the lower chamber 12.

0052 The outer-periphery covering mechanism 40 includes a cover member 41 and a support member 42. The cover member 41 is disposed in the lower chamber 12 and has an annular (doughnut) shape in plan view so as to cover only a peripheral edge portion of the wafer W placed on the platen 15 when the platen 15 is lifted, thereby functioning as a mask for etching. The support member 42 is formed annularly on an inner wall of the lower chamber 12 to support the cover member 41. The support member 42 is configured to support an outer peripheral edge of the cover member 41. Note that this embodiment is configured such that the cover member 42 supports the cover member 41 at the entire outer peripheral edge of the support member 41; however, the present invention is not limited thereto. For example, a configuration is possible in which inwardly protruding members are provided at several (for example, four) positions on the inner wall of the lower chamber 12 and the cover member 41 is supported by the inwardly protruding members. Note further that this embodiment is configured such that the platen 15 on which a wafer W is to be placed is lifted and lowered; however, the present invention is not limited thereto. A configuration is possible in which the platen 15 is fixed and the cover member 41 is lifted and lowered instead. Note further that the outer-periphery covering mechanism 40 in the example described here is configured to have a shape which allows the recess 70c to be etched to have a circular planar shape; however, the present invention is not limited thereto. For example, the outer-periphery covering mechanism 40 may be configured to allow the recess 70c to be etched to have a non-circular planar shape, such as a rectangular planar shape, a rounded quadrangular planar shape (quadrangular planar shape with rounded corners), or a polygonal planar shape. Thus, the recess 70c can be formed into any shape by changing the shape of the cover member 41. Further, the problem of shavings produced in grinding or the like is avoided.

0053 The cover member 41 is made of a ceramic material, such as alumina (aluminum oxide), in view of etching selectivity of the cover member 41 and the wafer W. However, the present invention is not limited thereto. The cover member 41 may be made of yttrium or a material having a low dielectric constant, such as quartz. Alternatively, the cover member 41 may be made of a material made by coating alumna, quartz, or yttrium with a metal coating such as a nickel coating.

0054 Using aluminum oxide is disadvantageous in that sputtering is likely to occur in an etching process as described later and such sputtering leads to deterioration of surface accuracy of the surface Pa of the thin-plate part 70a, while it is advantageous in that the cover member 41 is inexpensive to manufacture. Using yttria is disadvantageous in that the cover member 41 is expensive to manufacture, while it is advantageous in that, even when sputtering as described above occurs, the product of the sputtering is likely to disappear and therefore the surface accuracy of the surface Pa of the thin-plate part 70a is less deteriorated. Using quartz is advantageous in that the cover member 41 is less expensive to manufacture than in the case of using yttria and in that, even when sputtering as described above occurs, the product of the sputtering disappears and therefore the surface accuracy of the surface Pa of the thin-plate part 70a is hardly deteriorated. In the case of using quartz, although the cover member 41 is etched by an etching species, loading is alleviated by the etching of the cover member 41, so that the thin-plate part 70a is etched to have a uniform thickness.

0055 Next, operation of the outer-periphery covering mechanism 40 is described.

0056 First, when the platen 15 has been lowered by the lifting cylinder 18, the cover member 41 is supported by the support member 42 at the outer peripheral edge thereof. In this state, a wafer W, which is not yet etched, is placed onto the platen 15. Subsequently, the platen 15 and the wafer W placed thereon are lifted by the lifting cylinder 18 for an etching process, whereby the cover member 41 is brought into contact with an upper surface of a peripheral edge portion of the wafer W and then the cover member 41 is raised along with the lifted wafer W. In this process, only the peripheral edge portion of the wafer W placed on the platen 15 is covered by the cover member 41. The cover member 41 functions as a mask in the etching process.

0057 After the etching process is finished, the platen 15 is lowered by the lifting cylinder 18, whereby the cover member 41 is supported by the support member 42. In this state, the etched wafer W (semiconductor substrate 70) is unloaded from the etching apparatus 1, and a wafer W to be etched next is loaded into the etching apparatus 1 and placed onto the platen 15.

0058 Using this outer-periphery covering member 40 allows an outer peripheral area of a width of about 3 mm of the upper surface of the wafer W to remain unetched, so that only an inner area of the upper surface of the wafer W is etched and thereby the inner region of the wafer W is thinned. This configuration enables reduction of cracking and warpage of the etched wafer W (semiconductor substrate 70).

0059 Note that this embodiment is configured such that a wafer W is placed onto the upper member 16; however, the present invention is not limited thereto. For example, a configuration is possible in which an electrostatic chuck having an electrode plate clamped between a pair of insulating layers is used and an appropriate voltage is applied to the electrode plate so that a wafer W is attracted to and held on the electrostatic chuck. Such a configuration also provides the same effects as this embodiment.

0060 The exhaust device 20 includes an exhaust pipe 21 connected to a side surface of the lower chamber 12. The exhaust device 20 exhausts gas from the processing chamber 11 through the exhaust pipe 21 to set the pressure inside the processing chamber 11 to a predetermined pressure.

0061 The gas supply device 25 includes a gas supply unit 26 supplying SF₆ gas as a fluorine-containing gas, a gas supply unit 27 supplying O₂ gas as an oxygen-containing gas, and a supply pipe 29 which is at one end connected to an upper surface of the upper chamber 13 and at the other end branched and connected to the gas supply units 26 and 27. The SF₆ gas and O₂ gas supplied from the gas supply units 26 and 27 are supplied as the processing gas into the processing chamber 11 through the supply pipe 29.

0062 The plasma generating device 30 generates so-called inductively coupled plasma (ICP). The plasma generating device 30 consists of a spiral (annular) coil 31 disposed on the upper chamber 13 and an RF power supply (coil power supply unit) 32 supplying RF power to the coil 31. By RF power being supplied to the coil 31 by the RF power supply unit 32, plasma is generated from the processing gas supplied in the upper chamber 13.

0063 The RF power supply 35 supplies RF power to the platen 15 to produce a potential difference (bias potential) between the platen 15 and plasma, thereby making ions generated by the generation of plasma from the processing gas incident to the wafer W. Thereby, the wafer W is etched. Etching herein means dry etching (anisotropic etching or isotropic etching) or the like, such as RIE (Reactive Ion Etching) using a reaction gas.

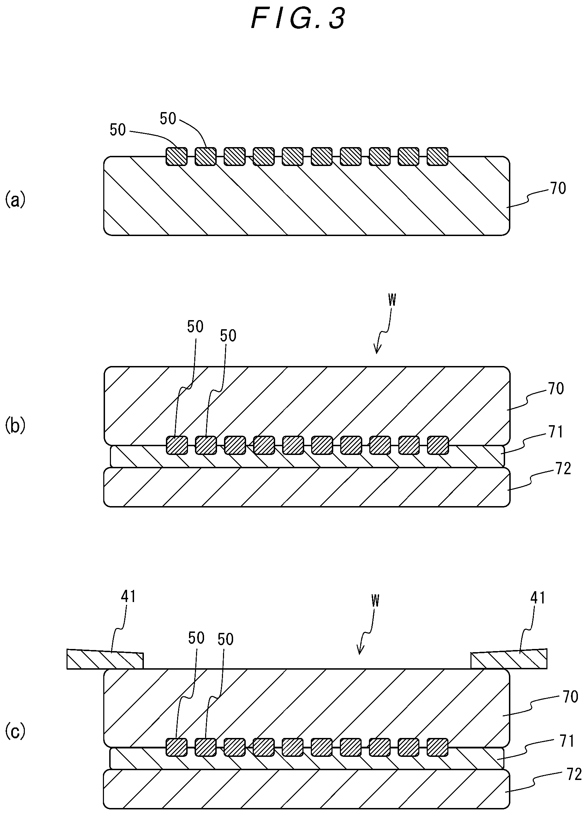

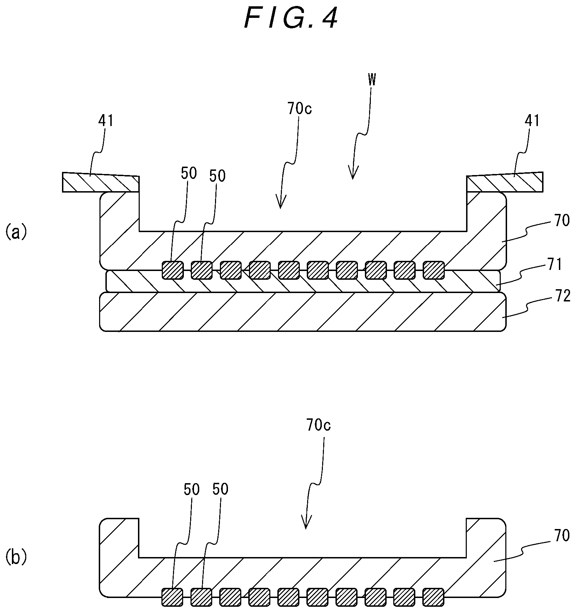

0064 Figs. 3 and 4 shows vertical sectional views showing steps of a method of manufacturing the semiconductor substrate 70 illustrated in Fig. 1. The method of manufacturing the semiconductor substrate 70 is now described below with reference to Figs. 3 and 4.

0065 First, a wafer W is manufactured in accordance with the following steps. That is to say, as shown in Fig. 3(a), a semiconductor substrate 70 having devices 50 formed on one surface thereof is prepared. This semiconductor substrate 70 has a typical circular-plate shape (having a thickness of 0.35 mm with respect to a diameter of 76 mm to 150 mm) and is made of silicon carbide.

0066 Subsequently, as shown in Fig. 3(b), an adhesive 71 is applied on the entire surface having the devices 50 formed thereon with an applier (not illustrated). For example, a spin coating method is used in which the semiconductor substrate 70 is rotated at high speed so that the adhesive 71, which is dropped, is spread over the entire surface having the devices 50 formed thereon by centrifugal force. Therefore, it is preferred that the adhesive 71 has an appropriate viscosity and is dropped in a liquid state onto the semiconductor substrate 70. For example, a polyimide adhesive or an acrylic adhesive is used as the adhesive 71. Subsequently, a carrier substrate 72 is affixed to the semiconductor substrate 70 via the adhesive 71. This carrier substrate 72 protects the devices 50. Note that the devices 50 may be protected by, for example, only a protective coating material without affixing the carrier substrate 72. In such a case, it is unnecessary to affix the carrier substrate 72.

0067 The configuration described above enables the carrier substrate 72 (see Fig. 3(c)) to be affixed to the semiconductor substrate 70 with the surface having the devices 50 formed thereon protected. The configuration further makes it easy to remove the carrier substrate 72 after the semiconductor substrate 70 is thinned.

0068 Thereafter, the wafer W is loaded into the processing chamber 11 of the etching apparatus 1 and placed onto the platen 15 (the upper member 16) such that the surface not having the devices 50 formed thereon faces upward as an upper surface. When this process is carried out, the platen 15 has been lowered and the cover member 41 is supported by the support member 42. Subsequently, as shown in Fig. 3(c), the wafer W is lifted together with the platen 15, and simultaneously the cover member 41 is raised via an outer peripheral edge of the wafer W. Thereby, a peripheral portion of a width of about 3 mm of the upper surface of the wafer W is masked by the cover member 41. By plasma etching the wafer W in this state, only the area inside the peripheral portion of the upper surface of the wafer W is etched with only the peripheral portion remaining unetched. That is to say, it is possible to thin an inner region of the wafer W. Note that it is preferred that the inner diameter of the cover member 41 is determined such that a peripheral portion of a radial width of 1mm to 10 mm of the upper surface of the semiconductor substrate 70 is covered by the cover member 41, in other words, so that the thick-plate part (second substrate region) 70b of the semiconductor substrate 70 has a radial width of 1mm to 10 mm. This is because the thick-plate part 70b as having a width smaller than 1 mm makes the semiconductor substrate 70 insufficient in strength, while the thick-plate part 70b as having a width greater than 10 mm makes an effective area for device formation. Particularly, the effective area greatly depends on the shape and size of each device, arrangement of the devices, and the shape of the recess 70c where the devices are formed. In the case where the recess 70c has a circular planar shape, it is preferred that the thick-plate part 70b has a width of 5 mm or less. In the case where the recess 70c has a polygonal planar shape, in some cases, the semiconductor substrate 70 has a sufficient effective area for device formation even when the thick-plate part 70b has a width of 5 mm or more.

0069 Subsequently, as shown in Fig. 4(a), the upper surface of the semiconductor substrate 70 is etched by a plasma etching technology, e.g., RIE (Reactive Ion Etching), with the cover member 41 used as a mask so that the recess 70c is formed. The conditions for the etching are as follows: SF₆ gas as an etching gas is suppled into the processing chamber 11 at a flow rate of 400 sccm; O₂ gas as an additive gas is supplied into the processing chamber 11 at a flow rate of 600 sccm; coil power supplied to the coil 31 is 2000 W; bias power supplied to the platen 15 is 700 W; and the pressure inside the processing chamber 11 is 12 Pa. Under these conditions, etching rate is approximately 6 µm/min. The O₂ gas as an additive gas is expected to provide the effect of enhancing reactivity with carbon (C) in silicon carbide (SiC) so as to increase the etching rate. Note that, although O₂ gas is used as an additive gas in the etching above, the semiconductor substrate 70 may be etched by using only SF₆ gas as an etching gas without using O₂ gas.

0070 Note that the coil power can be set in a range of 400 to 5000 W. In view of plasma stability, it is particularly preferred that it is 1500 W or more. Further, the bias power can be set in a range of 50 to 1000 W. In view of plasma stability, it is particularly preferred that it is 500 W or more. The pressure inside the processing chamber 11 can be set in a range of 0.5 to 50 Pa. In view of the in-plane uniformity of etching amount, it is particularly preferred that it is 3 Pa or more up to 30 Pa.

0071 After the upper surface of the semiconductor substrate 71 is etched in the above-described manner and thereby the recess 70c having a predetermined depth is formed, the etching process is ended and the wafer W is unloaded from the processing chamber 11. Thereafter, a backside electrode is formed with a sputtering device or the like.

0072 Differently from the conventional art, this thinning method does not require grinding. Therefore, it is unnecessary to carry out a stress relief process using CMP or the like in order to remove grinding distortion, such as a damaged layer, generated in grinding, which enables reduction of manufacturing time and manufacturing cost. Furthermore, even thinning of a recess with a small rectangular area can be facilitated by changing the shape of the cover.

0073 Note that this embodiment is configured such that the etching apparatus 1 has a mechanism for covering the non-etched portion of the wafer W; however, the present invention is not limited thereto. For example, a configuration is possible in which a mechanism for covering the non-etched portion of the wafer W is attached to the wafer W.

0074 Thereafter, as shown in Fig. 4(b), the carrier substrate 72 is peeled off from the adhesive 71 and then the adhesive 71 is removed.

0075 The semiconductor substrate 70 according to this embodiment that is manufactured in the above-described manner has a large thickness at its outer peripheral portion (second substrate region) and has a small thickness only at its inner region (first substrate region) for device formation. Therefore, cracking and warpage of the semiconductor substrate 70 are reduced. Further, since the semiconductor substrate 70, on which the devices 50 are formed, is made of silicon carbide and has a minimum thickness (not less than 10 µm and not more than 50 µm) as well as high withstand voltage, the devices 50 have lower power loss than a device manufactured with silicon.

0076 Further, the manufacturing method according to this embodiment for manufacturing the semiconductor substrate 70, the semiconductor substrate 70 made of silicon carbide that has high hardness can be thinned to a minimum thickness (not less than 10 µm and not more than 50 µm) having high voltage withstanding property by a plasma etching method without depending on mechanical grinding. Therefore, expensive abrasives for grinding are not needed, which greatly reduces manufacturing cost.

0077

### [Second Embodiment]

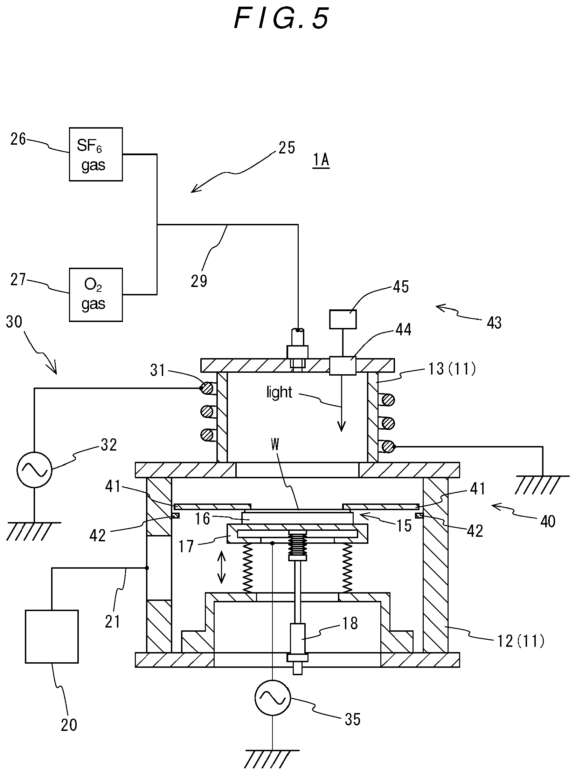

Next, a second embodiment of the present invention is described based on Fig. 5. Fig. 5 is a sectional view of a schematic configuration of an etching apparatus 1A according to the second embodiment. The etching apparatus 1A is different from the etching apparatus 1 illustrated in Fig. 2 in that the etching apparatus 1A is configured to further include a spectroscopic depth monitor 43 which is capable of measuring (monitoring) the depth of etching of a wafer W in real time. Accordingly, in Fig. 5, components identical to those of the etching apparatus 1 illustrated in Fig. 2 are denoted by the same reference numerals as in Fig. 2 and detailed description thereof is omitted in the description below.

0078 The depth monitor 43 includes a depth sensor 44 and a processing unit 45. The depth sensor 44 includes a multi-wavelength light source (not illustrated) radiating a white light toward the surface to be etched of the wafer W and the cover member 41, a light receiving unit (not illustrated) receiving reflected lights from the wafer W and the cover member 41, and a spectrophotometer (not illustrated). The depth sensor 44 obtains a depth signal which changes in accordance with the depth of etching, and outputs the obtained depth signal to the processing unit 45.

0079 The depth sensor 44 is embedded in the upper surface of the upper chamber 13 and arranged to face the surface of the wafer W and the surface of the cover member 41. During etching of the wafer W, a white light is radiated from the light source toward the wafer W and the cover member 41, and reflected lights from the wafer W and the cover member 41 are received by the light receiving unit. The spectrophotometer measures intensity of light at each wavelength in a predetermined wavelength range for each of the reflected lights and transmits light intensity data obtained to the processing unit 45. The light intensity data is a depth signal in which the depth of etching is reflected and which changes in accordance with the depth of etching. The processing unit 45 generates based on the light intensity data a spectrum representing the intensity of light at each wavelength, and uses the generated spectrum to calculate the depth of etching based on a phase difference between the reflected light reflected by the etched surface of the wafer W and the reflected light reflected by the cover member 41.

0080 Note that the reflected light reflected by the wafer W and the reflected light reflected by the cover member 41 interfere with each other. The manner of interference between their light waves changes in accordance with the depth of the wafer W; therefore, this change of the manner of interference can be used to calculate the depth of etching.

0081 The method of manufacturing the semiconductor substrate 70 with the etching apparatus A1 according to this embodiment provides the same effects as the manufacturing method using the etching apparatus 1 according to the first embodiment. Further, the etching apparatus A1 according to this embodiment is capable of monitoring the etching depth in real time; therefore, the etching apparatus 1A can start etching without carrying out previous steps such as measuring in advance an etching amount and calculating an etching rate so as to recognize an etching end point based on the etching rate and an etching time. Therefore, as compared with the etching apparatus 1 according to the first embodiment, the etching apparatus 1A according to this embodiment greatly reduces the manufacturing time.

0082 Hereinbefore, specific embodiments of the present invention have been described. However, the present invention is not limited to the embodiments described above and can be implemented differently.

0083 For example, in the above embodiments, silicon carbide having a crystal structure of 4H-SiC is used as the semiconductor substrate 70. However, the material of the semiconductor substrate 70 is not limited to such silicon carbide and may be, for example, silicon carbide having a crystal structure other than 4H-SiC (6H-SiC or 3C-SiC), gallium nitride (GaN), gallium oxide (GaO), or diamond (C). In such cases, the same effects as those in the above embodiments are provided.

0084 Further, in the above embodiments, the semiconductor substrate according to the present invention is manufactured by using the etching apparatus 1 or the etching apparatus 1A. However, the manufacturing method according to the present invention may be implemented by using an etching apparatus configured differently from them. Further, the above embodiments are configured such that the devices 50 are first formed on the semiconductor substrate 70 and then the inner region (first substrate region), where the devices 50 are formed, of the semiconductor substrate 70 is thinned. However, the present invention is not limited to such a configuration. For example, a configuration is possible in which the inner region (first substrate region) of the semiconductor substrate 70 is first thinned and then the devices 50 are formed in the thinned region (thin-plate part) of the semiconductor substrate 70.

0085 Further, instead of the fluorine-containing gas (SF₆ gas) used as the etching gas in the above embodiments, for example, a chlorine-containing gas, such as Cl₂ gas, BCl₃ gas, CCl₄ gas, or SiCl₄ gas, may be used. The manufacturing method using such a gas also provides the same effects as the above manufacturing methods.

0086 Further, the foregoing description of the above embodiments describes an example in which the etching apparatus 1, 1A has a covering mechanism provided thereon which covers only a peripheral edge portion of the semiconductor substrate 70 so that only the peripheral edge portion is not etched. However, the present invention is not limited to such a configuration. For example, a configuration is possible in which a case for inserting the wafer W therein is used and the case has a cover provided thereon which covers only a peripheral edge portion of the semiconductor substrate 70 so that only the peripheral edge portion is not etched. Alternatively, a configuration is possible in which an etching mask, such as a photoresist mask, a oxide film mask, or a metal mask, is formed on a peripheral edge portion of the semiconductor substrate 70 so that only the peripheral edge portion is not etched.

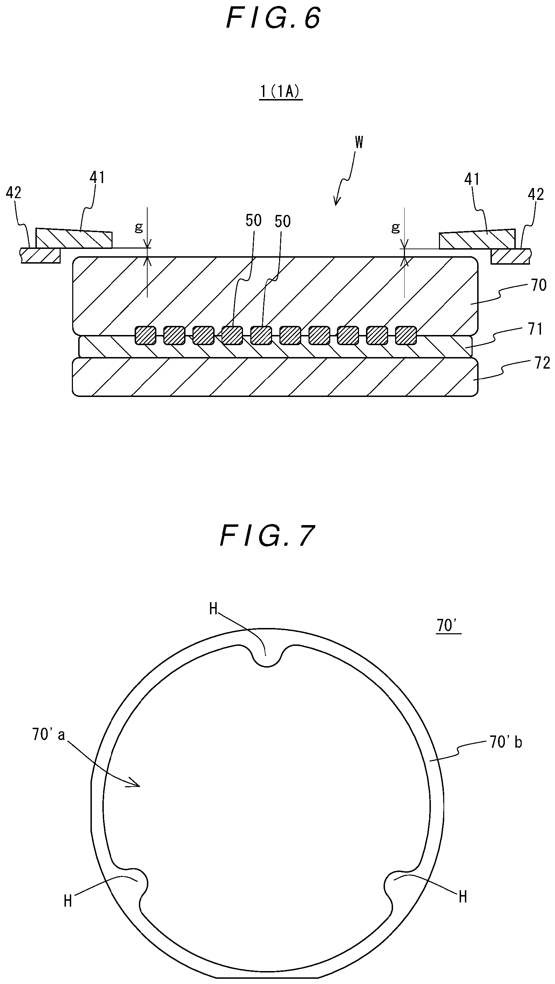

0087 Further, the above embodiments are configured such that etching is performed with the cover member 41 placed on the semiconductor substrate 70. However, the manufacturing apparatus (etching apparatus) and manufacturing method according to the present invention are not limited to such a configuration. As shown in Fig. 6, the etching apparatus A, A1 may be configured such that the cover member 41 is supported by the support member 42 such that a gap g is formed between the upper surface of the semiconductor substrate 70 and the lower surface of the cover member 41 when the platen 15 reaches a lifting end. Further, the manufacturing method may be configured such that etching is performed with the gap g formed between the upper surface of the semiconductor substrate 70 and the lower surface of the cover member 41.

0088 In the case where the cover member 41 is contact with the semiconductor substrate 70 when the semiconductor substrate 70 is etched in a state where a bias potential is applied to the platen 15, depending on the material of the cover member 41 (for example, in the case of alumina), a bias potential is generated in the cover member 41. This causes a problem that the cover member 41 is sputtered by ions in the plasma and the product of the sputtering adheres to the surface of the inner region of the semiconductor substrate 70, i.e., the surface of the thin-plate part 70a (the recess 70c), which deteriorates surface accuracy of the surface of the thin-plate part 70a. Accordingly, a gap g is formed between the semiconductor substrate 70 and the cover member 41 so that a bias potential is not generated in the cover member 41. Thereby, the surface accuracy of the upper surface of the thin-plate part 70a is prevented from being deteriorated due to the cover member 41 being sputtered.

0089 Note that it is preferred that the gap g between the semiconductor substrate 70 and the cover member 41 is not less than 0.5 mm and not more than 3 mm. In the case where the gap g is smaller than 0.5 mm, generation of a bias potential in the cover member 41 is not effectively prevented. In the case where the gap g is equal to or greater than 3 mm, an etching species enters between the semiconductor substrate 70 and the cover member 41 and etches the region covered by the cover member 41 (the second substrate region) of the semiconductor substrate 70, which causes a problem that the shape of the semiconductor substrate 70 obtained is deteriorated, e.g., an inner peripheral edge (inner shoulder) of the second substrate region (thick-plate part) being etched.

0090 According to the invention, the semiconductor substrate 70 has one or more protrusions which protrude in the radially inward direction from the second substrate region (thick-plate part). A semiconductor substrate having such protrusions is illustrated in Fig. 7. The semiconductor substrate 70' illustrated in Fig. 7 has three protrusions H, and the three protrusions H are arranged at equal intervals in the circumferential direction of the second substrate region 70'b. For example, if the thin-plate part 70'a is supported by support pins when the semiconductor substrate 70' is supported at the recess 70'c side in the above-described steps of peeling off the carrier substrate 72 and removing the adhesive 71, the support pins can pierce the supported portions of the thin-plate part 70'a because the thin-plate part 70'a has very small thickness. Accordingly, inwardly protruding protrusions H are formed on the thick-plate part (second substrate region) 70'b so that the protrusions H that has large thickness are supported by the support pins. This configuration can increase the area of the thin-plate part 70'a as much as possible so that the number of devices is increased, and simultaneously can prevent the disadvantage that the semiconductor substrate 70' is pierced by the support pins. Note that the number of protrusions H provided is not particularly limited. However, in view of stably supporting the semiconductor substrate 70', it is preferred that three or more protrusions H are formed and the protrusions H are arranged at equal intervals in the circumferential direction of the second substrate region 70'b.

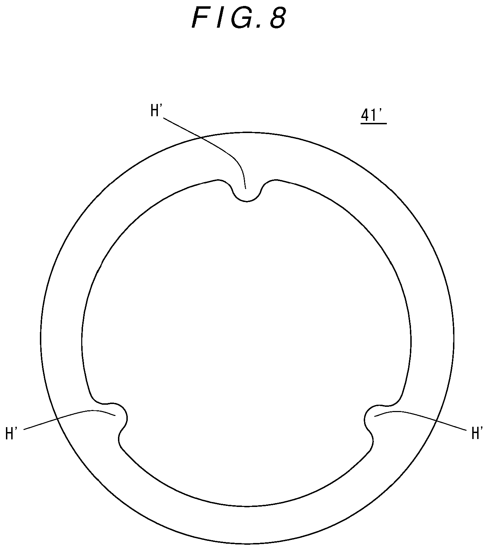

0091 Furthermore, in order to form such protrusions H, the cover member 41 of the above-described etching apparatus A, A1 also needs to have one or more, preferably three or more, protrusions protruding in the radially inward direction. In the case where two or more protrusions are provided, it is preferred that the protrusions are arranged at equal intervals in the circumferential direction. For the sake of clarity, a cover member having such protrusions is illustrated in Fig. 8. In Fig. 8, reference numeral 41' denotes the cover member and reference numeral H' denotes the protrusions.

0092 As have been mentioned, the above-described embodiments are given by way of example only, and various modifications are possible without departing from the scope of the present invention, which is defined by the claims.

### Reference Signs List

0093
- 1, 1A: Etching apparatus
- 11: Processing chamber
- 15: Platen
- 20: Exhaust device
- 25: Gas supply device
- 26, 27: Gas supply unit
- 30: Plasma generating device
- 31: Coil
- 32, 35: RF power supply
- 41: Cover member
- 42: Support member
- 43: Depth monitor
- 44: Depth sensor
- 45: Processing unit
- 50: Device
- 70: (Wide-gap) semiconductor substrate
- 70a: Thin-plate part (first substrate region)
- 70b: Thick-plate part (second substrate region)
- 70c: Recess
- 71: Adhesive
- 72: Carrier substrate
- W: Wafer

## Claims

1. A wide-gap semiconductor substrate (70') as a semiconductor substrate (70') having:
a first substrate region (70a') as an inner region having a first thickness; and
a second substrate region (70b') surrounding an outer periphery of the first substrate region (70a') and having a second thickness greater than the first thickness,
the first thickness of the first substrate region (70a') being not less than 10 µm and not more than 50 µm; and
the second substrate region (70b') being formed to have the second thickness of 100 µm to 350 µm and set to have a radial width of 1 mm to 10 mm,
wherein the semiconductor substrate (70') is a wide-gap semiconductor substrate having no device (50) formed on the first substrate region (70a'),
**characterized in that**:
the second substrate region (70b') includes at least one protrusion (H') which protrudes in a radially inward direction.

2. The wide-gap semiconductor substrate (70') of claim 1, wherein the wide-gap semiconductor substrate (70') is made of silicon carbide (4H-SiC, 6H-SiC, or 3C-SiC), gallium nitride (GaN), gallium oxide (GaO), or diamond (C).

3. A wide-gap semiconductor substrate manufacturing apparatus (1) etching a wide-gap semiconductor substrate (70') placed on a platen (15) disposed in a processing chamber (11) by means of plasma generated from an etching gas comprising:
an outer-periphery covering mechanism (40) including a cover member (41') covering, during etching of the wide-gap semiconductor substrate (70'), only a peripheral edge portion of the wide-gap semiconductor substrate (70') placed on the platen (15), and configured to cause only a region not covered by the cover member (41') to be etched,
wherein
the cover member (41') is configured to be placed in contact on the peripheral edge portion of the wide-gap semiconductor substrate (70'); **characterized in that**
the wide-gap semiconductor substrate manufacturing apparatus (1) is configured to thin the wide-gap semiconductor substrate (70') by etching so as to form a recess (70c) in the wide-gap semiconductor substrate (70'); and
the cover member (41') includes at least one protrusion (H') which protrudes in a radially inward direction.

4. The wide-gap semiconductor substrate manufacturing apparatus (1) of claim 3 wherein
the outer-periphery covering mechanism (40) further includes a support member (42) provided in the processing chamber (11) and supporting the cover member (41'); and
the outer-periphery covering mechanism (40) is configured such that the cover member (41') is brought into contact with and raised by the peripheral edge portion of the wide-gap semiconductor substrate (70') when the wide-gap semiconductor substrate (70') is lifted by the platen (15), thereby covering only the peripheral edge portion of the wide-gap semiconductor substrate (70') placed on the platen (15) so that only the peripheral edge portion is not etched.

5. The wide-gap semiconductor substrate manufacturing apparatus (1) of claim 3 or 4, wherein that the cover member (41') is made of quartz, aluminum oxide, or yttria or made of a material made by coating quartz, aluminum oxide, or yttria with a metal coating.

6. The wide-gap semiconductor substrate manufacturing apparatus (1) of any one of claims 3 to 5, wherein
the wide-gap semiconductor substrate manufacturing apparatus (1) further comprises a depth monitor (43) detecting a depth of etching of the wide-gap semiconductor substrate (70'); and
the depth monitor (43) includes:
a depth sensor (44) including a light source radiating a light toward an etched surface of the wide-gap semiconductor substrate (70') and the cover member (41'); and
a processing unit (45) calculating the depth of etching based on reflected lights reflected by the etched surface and the cover member (41').

7. The wide-gap semiconductor substrate manufacturing apparatus (1) of any one of claims 3 to 6, wherein the wide-gap semiconductor substrate (70') is made of silicon carbide (4H-SiC, 6H-SiC, or 3C-SiC), gallium nitride (GaN), gallium oxide (GaO), or diamond (C).

8. A wide-gap semiconductor substrate manufacturing method etching a wide-gap semiconductor substrate (70') placed on a platen (15) disposed in a processing chamber (11) by means of plasma generated from an etching gas comprising:
placing the wide-gap semiconductor substrate (70') onto the platen (15) disposed in the processing chamber (11) and covering with a cover member (41') only a peripheral edge portion where no device (50) is formed of the wide-gap semiconductor substrate (70');
supplying the etching gas into the processing chamber (11) and generating the plasma from the etching gas; and
etching the wide-gap semiconductor substrate (70');
wherein
the cover member (41') is placed in contact on the peripheral edge portion of the wide-gap semiconductor substrate (70'); **characterized in that** the cover member (41') includes at least one protrusion (H') which protrudes in a radially inward direction, and
during the etching of the wide-gap semiconductor substrate (70'), only a device formation region of the wide-gap semiconductor substrate (70') is thinned by etching so as to form a recess (70c) in the wide-gap semiconductor substrate (70').

9. The wide-gap semiconductor substrate manufacturing method of claim 8, wherein the cover member (41') is made of quartz, aluminum oxide, or yttria or made of a material made by coating quartz, aluminum oxide, or yttria with a metal coating.

10. The wide-gap semiconductor substrate manufacturing method of claim 8 or 9, wherein the wide-gap semiconductor substrate (70') is etched to have a thickness of 50 µm or less.

11. The wide-gap semiconductor substrate manufacturing method of any one of claims 8 to 10, wherein the etching gas includes a fluorine-containing gas.

12. The wide-gap semiconductor substrate manufacturing method of any one of claims 8 to 11, wherein the wide-gap semiconductor substrate (70') is made of silicon carbide (4H-SiC, 6H-SiC, or 3C-SiC), gallium nitride (GaN), gallium oxide (GaO), or diamond (C).

## Patentansprüche

1. Halbleitersubstrat mit breiter Bandlücke (70') als Halbleitersubstrat (70'), das Folgendes aufweist:
einen ersten Substratbereich (70a') als einen inneren Bereich mit einer ersten Dicke; und
einen zweiten Substratbereich (70b'), der einen Außenumfang des ersten Substratbereichs (70a') umgibt und eine zweite Dicke aufweist, die größer ist als die erste Dicke,
wobei die erste Dicke des ersten Substratbereichs (70a') nicht unter 10 µm und nicht über 50 µm beträgt; und
der zweite Substratbereich (70b') so ausgebildet ist, dass die zweite Dicke 100 µm bis 350 µm beträgt, und so vorgesehen ist, dass er eine radiale Breite von 1 mm bis 10 mm aufweist,
wobei das Halbleitersubstrat (70') ein Halbleitersubstrat mit breiter Bandlücke ist, bei dem auf dem ersten Substratbereich (70a') kein Bauelement (50) vorgesehen ist,
**dadurch gekennzeichnet, dass**:
der zweite Substratbereich (70b') mindestens einen Vorsprung (H') aufweist, der in eine Richtung radial nach innen vorsteht.

2. Halbleitersubstrat mit breiter Bandlücke (70') nach Anspruch 1, wobei
das Halbleitersubstrat mit breiter Bandlücke (70') aus Siliciumcarbid (4H-SiC, 6H-SiC oder 3C-SiC), Galliumnitrid (GaN), Galliumoxid (GaO) oder Diamant (C) gefertigt ist.

3. Vorrichtung (1) zum Herstellen eines Halbleitersubstrats mit breiter Bandlücke, mit der ein Halbleitersubstrat mit breiter Bandlücke (70'), das auf einer Platte (15) platziert ist, die in einer Behandlungskammer (11) angeordnet ist, mit Plasma geätzt wird, das aus einem Ätzgas erzeugt wird, umfassend:
einen den Außenumfang bedeckenden Mechanismus (40), der ein Abdeckelement (41') aufweist, das während des Ätzens des Halbleitersubstrats mit breiter Bandlücke (70') lediglich einen Umfangsrandabschnitt des Halbleitersubstrats mit breiter Bandlücke (70') bedeckt, das auf der Platte (15) platziert ist, und so ausgelegt ist, dass lediglich ein Bereich geätzt wird, der nicht vom Abdeckelement (41') bedeckt ist,
wobei das Abdeckelement (41') so ausgelegt ist, dass es kontaktierend auf dem Umfangsrandabschnitt des Halbleitersubstrats mit breiter Bandlücke (70') platziert ist;
**dadurch gekennzeichnet, dass**
die Vorrichtung (1) zum Herstellen eines Halbleitersubstrats mit breiter Bandlücke so ausgelegt ist, dass sie das Halbleitersubstrat mit breiter Bandlücke (70') durch Ätzen so ausdünnt, dass in dem Halbleitersubstrat mit breiter Bandlücke (70') eine Aussparung (70c) gebildet wird; und
das Abdeckelement (41') mindestens einen Vorsprung (H') aufweist, der in eine Richtung radial nach innen vorsteht.

4. Vorrichtung (1) zum Herstellen eines Halbleitersubstrats mit breiter Bandlücke nach Anspruch 3, wobei
der den Außenumfang bedeckende Mechanismus (40) ferner ein Trägerelement (42) aufweist, das in der Behandlungskammer (11) vorgesehen ist und das Abdeckelement (41') trägt; und
der den Außenumfang bedeckende Mechanismus (40) so ausgelegt ist, dass das Abdeckelement (41') mit dem Umfangsrandabschnitt des Halbleitersubstrats mit breiter Bandlücke (70') in Kontakt gebracht und von ihm angehoben wird, wenn das Halbleitersubstrat mit breiter Bandlücke (70') von der Platte (15) nach oben bewegt wird, wodurch lediglich der Umfangsrandabschnitt des Halbleitersubstrats mit breiter Bandlücke (70') bedeckt wird, das auf der Platte (15) platziert ist, sodass nur der Umfangsrandabschnitt nicht geätzt wird.

5. Vorrichtung (1) zum Herstellen eines Halbleitersubstrats mit breiter Bandlücke nach Anspruch 3 oder 4, wobei
das Abdeckelement (41') aus Quarz, Aluminiumoxid oder Yttriumoxid ist oder aus einem Material ist, das durch Beschichten von Quarz, Aluminiumoxid oder Yttriumoxid mit einer Metallbeschichtung hergestellt ist.

6. Vorrichtung (1) zum Herstellen eines Halbleitersubstrats mit breiter Bandlücke nach einem der Ansprüche 3 bis 5, wobei:
die Vorrichtung (1) zum Herstellen eines Halbleitersubstrats mit breiter Bandlücke ferner eine Tiefenüberwachungsvorrichtung (43) umfasst, die eine Ätztiefe im Halbleitersubstrat mit breiter Bandlücke (70') erfasst; und
die Tiefenüberwachungsvorrichtung (43) Folgendes aufweist:
einen Tiefensensor (44), der eine Lichtquelle aufweist, die ein Licht auf eine geätzte Fläche des Halbleitersubstrats mit breiter Bandlücke (70') und das Abdeckelement (41') ausstrahlt; und
eine Verarbeitungseinheit (45), die die Ätztiefe auf Grundlage von Reflexionslicht berechnet, das von der geätzten Fläche und dem Abdeckelement (41') reflektiert wird.

7. Vorrichtung (1) zum Herstellen eines Halbleitersubstrats mit breiter Bandlücke nach einem der Ansprüche 3 bis 6, wobei
das Halbleitersubstrat mit breiter Bandlücke (70') aus Siliciumcarbid (4H-SiC, 6H-SiC oder 3C-SiC), Galliumnitrid (GaN), Galliumoxid (GaO) oder Diamant (C) ist.

8. Verfahren zum Herstellen eines Halbleitersubstrats mit breiter Bandlücke, mit dem ein Halbleitersubstrat mit breiter Bandlücke (70'), das auf einer Platte (15) platziert ist, die in einer Behandlungskammer (11) angeordnet ist, mit Plasma geätzt wird, das aus einem Ätzgas erzeugt wird, umfassend:
Platzieren des Halbleitersubstrats mit breiter Bandlücke (70') auf der Platte (15), die in der Behandlungskammer (11) angeordnet ist, und mit einem Abdeckelement (41') zum Abdecken von lediglich einem Umfangsrandabschnitt, wo kein Bauelement (50) vorgesehen ist, des Halbleitersubstrats mit breiter Bandlücke (70');
Einleiten des Ätzgases in die Behandlungskammer (11) und Erzeugen des Plasmas aus dem Ätzgas; und
Ätzen des Halbleitersubstrats mit breiter Bandlücke (70');
wobei
das Abdeckelement (41') kontaktierend auf dem Umfangsrandabschnitt des Halbleitersubstrats mit breiter Bandlücke (70') platziert wird;
**dadurch gekennzeichnet, dass**
das Abdeckelement (41') mindestens einen Vorsprung (H') aufweist, der in eine Richtung radial nach innen vorsteht, und
während des Ätzens des Halbleitersubstrats mit breiter Bandlücke (70') lediglich ein Bauelementbildungsbereich des Halbleitersubstrats mit breiter Bandlücke (70') durch Ätzen ausgedünnt wird, damit in dem Halbleitersubstrat mit breiter Bandlücke (70') eine Aussparung (70c) gebildet wird.

9. Verfahren zum Herstellen eines Halbleitersubstrats mit breiter Bandlücke nach Anspruch 8, wobei
das Abdeckelement (41') aus Quarz, Aluminiumoxid oder Yttriumoxid ist oder aus einem Material ist, das durch Beschichten von Quarz, Aluminiumoxid oder Yttriumoxid mit einer Metallbeschichtung gefertigt ist.

10. Verfahren zum Herstellen eines Halbleitersubstrats mit breiter Bandlücke nach Anspruch 8 oder 9, wobei
das Halbleitersubstrat mit breiter Bandlücke (70') so geätzt wird, dass es eine Dicke von 50 µm oder weniger aufweist.

11. Verfahren zum Herstellen eines Halbleitersubstrats mit breiter Bandlücke nach einem der Ansprüche 8 bis 10, wobei
das Ätzgas ein fluorhaltiges Gas enthält.

12. Verfahren zum Herstellen eines Halbleitersubstrats mit breiter Bandlücke nach einem der Ansprüche 8 bis 11, wobei
das Halbleitersubstrat mit breiter Bandlücke (70') aus Siliciumcarbid (4H-SiC, 6H-SiC oder 3C-SiC), Galliumnitrid (GaN), Galliumoxid (GaO) oder Diamant (C) ist.

## Revendications

1. Substrat semiconducteur à large bande interdite (70') comme substrat semiconducteur (70') comportant :
une première région de substrat (70a') comme région interne ayant une première épaisseur ; et
une seconde région de substrat (70b') entourant une périphérie externe de la première région de substrat (70a') et ayant une seconde épaisseur plus grande que la première épaisseur,
la première épaisseur de la première région de substrat étant de pas moins de 10 µm et de pas plus de 50 µm ; et
la seconde région de substrat (70b') étant conçue pour avoir la seconde épaisseur de 100 µm à 350 µm et prévue pour avoir une largeur radiale de 1 mm à 10 mm,
le substrat de semiconducteur (70') étant un substrat de semiconducteur à large bande interdite n'ayant pas de dispositif (50) formé sur la première région de substrat (70a'),
**caractérisé en ce que** :
la seconde région de substrat (70b') comporte au moins une saillie (H') qui fait saillie dans une direction radialement vers l'intérieur.

2. Substrat semiconducteur à large bande interdite selon la revendication 1, dans lequel
le substrat semiconducteur à large bande interdite (70') est constitué de carbure de silicium (4H-SiC, 6H-SiC ou 3C-SiC), de nitrure de gallium (GaN), d'oxyde de gallium (GaO) ou de diamant (C).

3. Appareil (1) de fabrication de substrat semiconducteur à large bande interdite gravant un substrat semiconducteur à large bande interdite (70') placé sur une platine (15) disposée dans une chambre de traitement (11) au moyen d'un plasma produit à partir d'un gaz de gravure comprenant :
un mécanisme de couverture de périphérie externe (40) comprenant un élément de couverture (41') recouvrant, durant la gravure du substrat semiconducteur à large bande interdite (70'), seulement une portion de bord périphérique du substrat semiconducteur à large bande interdite (70') placée sur la platine (15) et configurée pour entraîner seulement une région non recouverte par l'élément de couverture (41') à être gravée,
l'élément de couverture (41') étant configuré pour être placé en contact sur la portion de bord périphérique du substrat semiconducteur à large bande interdite (70') ;
**caractérisé en ce que**
l'appareil (1) de fabrication de substrat semiconducteur à large bande interdite étant configuré pour amincir le substrat semiconducteur à large bande interdite (70') par gravure de manière à former un retrait (70c) dans le substrat semiconducteur à large bande interdite (70') ; et
l'élément de couverture (41') comporte au moins une saillie (H') qui fait saillie dans une direction radialement vers l'intérieur.

4. Appareil (1) de fabrication de substrat semiconducteur à large bande interdite selon la revendication 3 dans lequel
le mécanisme de couverture de périphérie externe (40) comprend en outre un élément de support (42) fourni dans la chambre de traitement (11) et supportant l'élément de couverture (41') ; et
le mécanisme de couverture de périphérie externe (40) est configuré de telle manière que l'élément de couverture (41') est mis en contact avec et monté par la portion de bord périphérique du substrat semiconducteur à large bande interdite (70') lorsque le substrat semiconducteur à large bande interdite est élevé par la platine (15), recouvrant ainsi seulement la portion de bord périphérique de substrat semiconducteur à large bande interdite (70') placé sur la platine (15) de telle sorte que seule la portion de bord périphérique n'est pas gravée.

5. Appareil (1) de fabrication de substrat semiconducteur à large bande interdite selon la revendication 3 ou 4, dans lequel
l'élément de couverture (41') est constitué de quartz, d'oxyde s'aluminium ou d'oxyde d'yttrium ou constitué d'un matériau constitué par revêtement de quartz, d'oxyde d'aluminium ou d'oxyde d'yttrium avec un revêtement de métal.

6. Appareil (1) de fabrication de substrat semiconducteur à large bande interdite selon l'une quelconque des revendications 3 à 5, dans lequel
l'appareil (1) de fabrication de substrat semiconducteur à large bande interdite comprend en outre un moniteur de profondeur (43) détectant une profondeur de gravure du substrat semiconducteur à large bande interdite (70') ; et
le moniteur de profondeur comprend :
un capteur de profondeur (44) comportant une source de lumière irradiant une lumière sur une surface gravée du substrat semiconducteur à large bande interdite (70') et de l'élément de couverture (41') ; et
une unité de traitement (45) calculant la profondeur de gravure sur la base des lumières réfléchies réfléchies par la surface gravée et l'élément de couverture (41').

7. Appareil (1) de fabrication de substrat semiconducteur à large bande interdite selon l'une quelconque des revendications 3 à 6, dans lequel
le substrat semiconducteur à large bande interdite (70') est constitué de carbure de silicium (4H-SiC, 6H-SiC ou 3C-SiC), de nitrure de gallium (GaN), d'oxyde de gallium (GaO) ou de diamant (C).

8. Procédé de fabrication de substrat semiconducteur à large bande interdite gravant un substrat semiconducteur à large bande interdite (70') placé sur une platine (15) disposée dans une chambre de traitement (11) au moyen d'un plasma produit à partir d'un gaz de gravure comprenant :
le placement du substrat semiconducteur à large bande interdite (70') sur la platine (15) disposée dans la chambre de traitement (11) et recouvrant avec un élément de couverture (41') seulement une portion de bord périphérique où aucun dispositif (50) n'est formé du substrat semiconducteur à large bande interdite (70') ;
l'introduction du gaz de gravure dans la chambre de traitement (11) et la production du plasma à partir du gaz de gravure ; et
la gravure du substrat semiconducteur à large bande interdite (70') ;
l'élément de couverture (41') étant placé en contact sur la portion de bord périphérique du substrat semiconducteur à large bande interdite (70') ;
**caractérisé en ce que**
l'élément de couverture (41') comporte au moins une saillie (H') qui fait saillie dans une direction radialement vers l'intérieur, et
durant la gravure du substrat semiconducteur à large bande interdite (70'), seule une région de formation de dispositif du substrat semiconducteur à large bande interdite (70') est amincie par gravure de manière à former un retrait (70c) dans le substrat semiconducteur à large bande interdite (70').

9. Procédé de fabrication de substrat semiconducteur à large bande interdite selon la revendication 8, dans lequel
l'élément de couverture (41') est constitué de quartz, d'oxyde d'aluminium ou d'oxyde d'yttrium ou constitué d'un matériau constitué par revêtement de quartz, d'oxyde d'aluminium ou d'oxyde d'yttrium avec un revêtement de métal.

10. Procédé de fabrication de substrat semiconducteur à large bande interdite selon la revendication 8 ou 9, dans lequel
le substrat semiconducteur à large bande interdite (70') est gravé pour avoir une épaisseur de 50 µm ou moins.

11. Procédé de fabrication de substrat semiconducteur à large bande interdite selon l'une quelconque des revendications 8 à 10, dans lequel
le gaz de gravure comprend un gaz contenant du fluor.

12. Procédé de fabrication de substrat semiconducteur à large bande interdite selon l'une quelconque des revendications 8 à 11, dans lequel
le substrat semiconducteur à large bande interdite (70') est constitué de carbure de silicium (4H-SiC, 6H-SiC ou 3C-SiC), de nitrure de gallium (GaN), d'oxyde de gallium (GaO) ou de diamant (C).
